# EUROPEAN PATENT SPECIFICATION

(11) **EP 2 244 541 B1**
(45) Date of publication and mention of the grant of the patent: **16.11.2011**
(21) Application number: 10172558.8
(22) Date of filing: 19.02.2008
(51) Int. Cl.: H05K 3/34, H05K 1/11, H05K 1/02

(54) **Method for mounting surface mount electronc devices**
Verfahren zum Aufbau von Oberflächen-Elektronikvorrichtungen
Procédé pour le montage en surface de dispositifs électroniques

(30) Priority: 22.02.2007 JP 2007042042; 27.07.2007 JP 2007195414; 06.09.2007 JP 2007231160
(43) Date of publication of application: 27.10.2010
(62) Divisional of application: 08250573.6
(73) Proprietor: SIIX Corporation, Chuo-ku Osaka 541-0051 (JP)
(72) Inventor: Matsushima, Yoshihiko, Chuo-ku Osaka 541-0051 (JP)
(74) Representative: South, Nicholas Geoffrey

(56) References cited:
- WO-A1-2005/074335
- DE-A1- 10 250 697
- DE-A1- 19 530 353
- JP-A- 2001 298 046
- US-A1- 2005 285 253

## Description

### BACKGROUND OF THE INVENTION

### (1) Field of the Invention

The present invention relates to a method for mounting surface mount electronic devices.

### (2) Description of the Related Art

In recent years, advances in the resin molding technology have lead to miniaturization of electronic devices. By virtue of the advances together with rapid advances in the surface mount technology, complicated circuits each composed of various electronic devices mounted on a single circuit board are provided.

Outstanding among these advances is introduction of electronic devices having an outer lead-wire, which allows mounting of the electronic devices directly onto a surface of a circuit board having wiring made thereon. A notable difference between mounting of surface mount electronic devices and of pin-mounting electronic devices is found in the heating method employed in a soldering process. With surface mount electronic devices, a whole heating method is commonly employed according to which an entire circuit board is heated in a reflow oven to carry out soldering.

Unfortunately, however, the whole heating method involves the following setback in the case where a surface mount electronic device is a molded-resin piece, especially where the shape of the molded-resin piece affects the operation performance. One example of such electronic devices is a light emitting diode (hereinafter "LED") equipped with a resin lens. In these cases, heat applied in the soldering process exerts adverse effects such as thermal deformation of a resin lens. As a result, the circuit performance may be deteriorated.

As an alternative to the whole heating method, a local heating method may be used to locally heat a soldering portion with a laser beam to carry out circuit mounting (as disclosed for example in JP Unexamined Patent Application Publication No. 9-205275).

The following briefly describes the heating method with a laser beam.

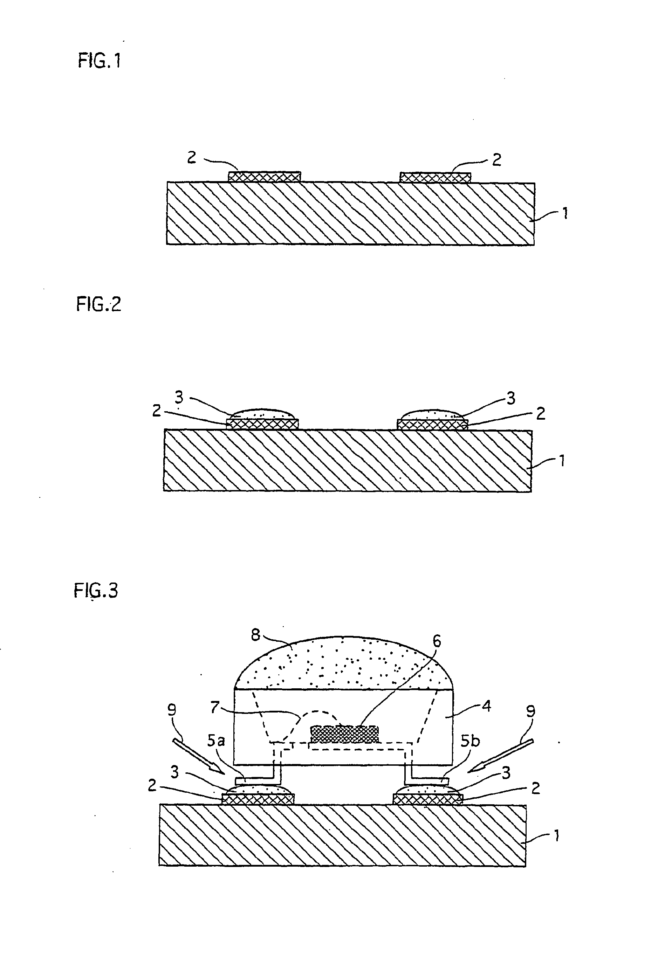

Fig. 1 is a sectional view of an important part of a surface mount circuit board, taken so as to show lands. An insulating substrate 1 that is a base of the circuit board has circuit wiring (not shown) formedona front surface thereof. Lands 2 connected to the wiring are disposed on the front surface of the insulating substrate 1.

In order to solder surface mount devices onto the circuit board shown in Fig. 1, the following processing step needs to be done in advance. That is, solder cream needs to be applied onto each land 2 by conventionally known screen printing. As a result of this processing step, a solder mound 3 is formed on each land 2 as shown in Fig. 2.

Fig. 3 shows an example of surface mounting in which an LED is mounted onto the surface mount circuit board shown in Fig. 2, by a local heating method using a laser beam. The LED has a resin stem 4 and a pair of outer lead-wires 5a and 5b extending from the resin stem 4. The LED is placed onto the circuit board, so that each of the outer lead-wire 5a and 5b is brought into engagement with a different one of the solder mounds 3. With this positional relation, the solder mounds 3 are locally heated with a laser beam 9 emitted by a laser heating apparatus (not shown). As a result, the solder mounds 3 melt and subsequently solidify to bond the outer lead-wires 5a and 5b to the respective lands 2. Note that an LED die 6 that makes up a base of the LED is attached to a die support that is connected to the outer lead-wire 5b. One of a pair of electrodes exposed on the surface of the LED die 6 is connected via a metal wire 7 to the outer lead-wire 5a. The resin stem 4 is sealed by a resin lens.

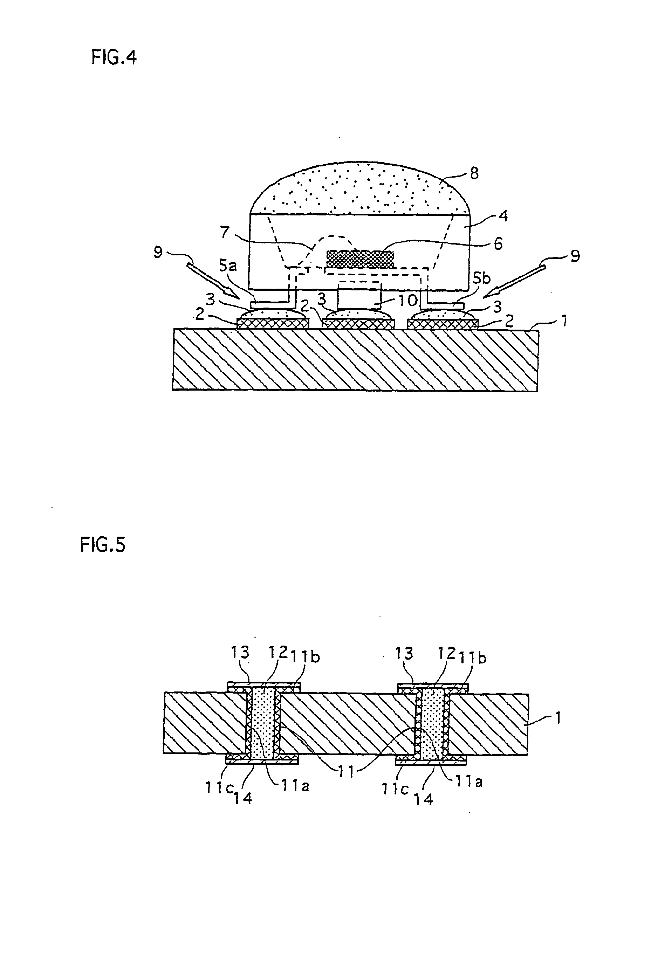

In one exemplary configuration shown in Fig. 4, the LED is provided with a heat-dissipating block 10 disposed directly below the LED die 6. In this case, another land 2 needs to be provided on the insulating substrate 1 for establishing thermal coupling between the land and the heat-dissipating block 10. In a similar manner to the soldering of the outer lead-wires 5a and 5b, the heat-dissipating block 10 is soldered.

According to the circuit mounting technology described above, heat is applied in the soldering process by locally irradiating a soldering location with the laser beam 9. Consequently, thermal effect imposed on the resin lens 8 of the LED is significantly smaller than that would be imposed as a result of the whole heating. This advantage eliminates the risk of thermal deformation of the resin lens 8.

Unfortunately, however, the local heating with a laser beam requires use of an expensive laser heating apparatus. Thus, the initial cost of setting up equipment for circuit mounting inevitably increases.

In addition, the local heating with a laser beam requires enough clearance to be reserved between electronic devices for allowing a laser beam to reach a soldering location. When the electronic devices need to be mounted on a circuit board at high density, there may be a case where a laser beam cannot be directed to an intended soldering location. In order to avoid such an undesirable case, locations of electronic devices on the circuit board need to be severely restricted.

Even if large clearances are secured between electronic devices, the following problem still remains in the case of soldering a heat dissipating block provided on a rear surface of the LED bottom as shown in Fig. 4. In such a case, it is still extremely difficult to allow a laser beam to reach a soldering location.

Relevant background art is disclosed in the following documents:
Document DE 195 30 353, which relates to soldering a flexible circuit board to a printed circuit board, discloses a method comprising forming a plurality of through holes each extending from front to rear surfaces of an insulating substrate and each at a location corresponding to where a land is to be formed; forming a plurality of lands on the front surface of the insulating substrate, so that each land is in contact with a part of the front surface around a peripheral edge of the corresponding through hole; forming a plurality of heat receiving members on the rear surface of the insulating substrate, so that each heat receiving member is in contact with a part of the rear surface around a peripheral edge of the corresponding through hole; applying solder to each land; and
heating the heat receiving members to melt the solder.

Document JP 2001 298046 discloses placing a circuit board on a flat surface of a heater and heating the substrate to a temperature below the melting point of the solder to prevent deformation of the substrate.

Documents DE 102 50 697 discloses filling thermally conductive material in through holes.

Document US 2005/285253 discloses fitting metal rods into through holes.

### SUMMERY OF THE INVENTION

The present invention is made in view of the above problems and aims to provide a solution that enables local heating of a soldering location with simple structure and in a manner to reduce thermal effect on electronic devices, without any restriction on locations of the electronic devices.

In one aspect of the present invention, a method for mounting surface mount electronic devices is provided as defined in claim 1. The method includes of: forming a plurality of through holes each extending from front to rear surfaces of an insulating substrate and each at a location corresponding to where a land is to be formed; filling a high thermal conductive material into the respective through holes to form a plurality of high thermal conductive members; forming a plurality of lands on the front surface of the insulating substrate, so that each land is in contact with a first end surface of a different one of the high thermal conductive members and part of the front surface around a peripheral edge of the corresponding through hole; forming a plurality of heat receiving members on the rear surface of the insulating substrate, so that each heat receiving member is in contact with a second end surface of a different one of the high thermal conductive members and with part of the rear surface around a peripheral edge of the corresponding through hole; applying solder to each land; placing a plurality of surface mount electronic devices each relatively to a different one of the lands, so that at least an outer lead-wire of the surface mount electronic device engages with the solder applied to the land; and heating the heat receiving members to melt the solder to bond the outer lead-wire of each surface mount electronic device to the corresponding land.

In another aspect of the present invention, an alternative method for mounting surface mount electronic devices is provided. The method includes the steps of: forming a plurality of through holes each extending from front to rear surfaces of an insulating substrate and each at a location corresponding to where a land is to be formed; fitting a plurality of metal rods each into a different one of the through holes, each metal rod being substantially equal in length to a thickness of the insulating substrate; forming a plurality of lands on the front surface of the insulating substrate, so that each land is in contact with a first end surface a different one of the metal rods and with part of the front surface around a peripheral edge of the corresponding through hole; forming a plurality of heat receiving members on the rear surface of the insulating substrate, so that each heat receiving member is in contact with a second end surface of a different one of the metal rods and with part of the rear surface around a peripheral edge of the corresponding through hole; applying solder to each land; placing a plurality of surface mount electronic devices each relatively to a different one of the lands, so that at least an outer lead-wire of the surface mount electronic device engages with the solder applied to the land; and heating the heat receiving members to melt the solder to bond the outer lead-wire of each surface mount electronic device to the corresponding, land.

According to any of the above methods, heating in the soldering process is carried out in a manner to reduce thermal effect imposed on the electronic devices. In addition, local heating of a soldering location is enabled with simple structure. Furthermore, restrictions are no longer imposed on locations of the electronic devices.

The method for mounting surface mount electronic devices includes a step of soldering the surface mount electronic devices, by locally heating the solder applied to each land disposed on the front surface of the insulating substrate until the melting point is reached. The local heating is achieved by applying heat from the rear surface of the insulating substrate.

### BRIEF DESCRIPTION OF THE DRAWINGS

These and the other objects, advantages and features of the invention will become apparent from the following description thereof taken in conjunction with the accompanying drawings which illustrate a specific embodiment of the invention.

In the drawings:
Fig. 1 is a sectional view of an important part of a surface mount circuit board, taken so as to show lands;
Fig. 2 is a sectional view of the surface mount circuit board in the state where solder is applied to the lands;
Fig. 3 shows an example of mounting an LED on the surface mount circuit board;
Fig. 4 shows an example of mounting an LED on the surface mount circuit board;
Fig. 5 is a sectional view of an important part of a surface mount circuit board used in the method according to a first embodiment of the present invention;
Fig. 6 is a sectional view of an important part of a surface mount circuit board according to an example;
Fig. 7 is a sectional view of an important part of a surface mount circuit board used in the method according to a second embodiment of the present invention;
Fig. 8 is a view illustrating a manufacturing step of the circuit board according to the example;
Fig. 9 is a view illustrating a manufacturing step of the circuit board according to the example;
Fig. 10 is a view illustrating a manufacturing step of the circuit board according to the example;
Fig. 11 is a view illustrating a manufacturing step of the circuit board according to the example;
Fig. 12 is a view illustrating a manufacturing step of the circuit board according to the example;
Fig. 13 is a view illustrating a manufacturing step of the circuit board according to the example;
Fig. 14 is a view illustrating a step of the method according to the second embodiment;
Fig. 15 is a view illustrating a step of the method according to the second embodiment;
Fig. 16 is a view illustrating a step of the method according to the second embodiment;
Fig. 17 is a view illustrating a step of the method according to the second embodiment;
Fig. 18 is view illustrating a step of mounting a light emitting diode onto the circuit board according to the first embodiment;
Fig. 19 is view illustrating a step of mounting a light emitting diode onto the circuit board; and
Fig. 20 is view illustrating a step of mounting a light emitting diode onto the circuit board according to the second embodiment.

### DESCRIPTION OF THE PREFERRED EMBODIMENTS

The following describes embodiments of the present invention with reference to the accompanying drawings.

Fig. 5 is a sectional view of an important part of a surfacemount circuit board used in the method according to a first embodiment of the present invention.

The surface mount circuit board in the method according to the first embodiment includes the insulating substrate 1 having a plurality of through holes. Each through hole is at a location where a land is to be formed and extends from the front to rear surfaces of the insulating substrate 1. In addition, each through hole is provided with a copper plating 11 that covers the entire inner wall of the through hole and also covers part of the front and rear surfaces of the insulating substrate 1 around the peripheral edges of the through hole. Each through hole covered with the copper plating 11 (part 11a) is filled with high thermal conductive epoxy resin 12 obtained by kneading copper powder. On the front surface of the insulating substrate 1, copper platings 13 are provided one for each through hole. Each copper plating 13 covers the end surface of the high thermal conductive epoxy resin 12 exposed at the front surface and also covers at least part of the copper plating 11 (part 11b). On the rear surface of the insulating substrate 1, copper platings 14 are provided one for each through hole. Each copper plating 14 covers the end surface of the high thermal conductive epoxy resin 12 exposed at the rear surface and also covers at least part of the copper plating 11 (part 11c). The copper platings 13 and 11b disposed on the front surface of the insulating substrate 1 together serve as a land. On the other hand, the copper platings 14 and 11c disposed on the rear surface of the insulating substrate 1 together serve as a heat receiving member. Here, a heat receiving member is a member used to receive heat from an external heater. The insulating substrate 1 has circuit wiring (not shown) formed on the front surface and one or more of the lands are connected to the circuit wiring.

In the surface mount circuit board having the above configuration, each land composed of the copper platings 13 and 11b is thermally coupled to a corresponding one of the heat receiving members each composed of the copper platings 14 and 11c via the high thermal conductive epoxy resin 12, which is a high thermal conductive material filling the through holes.

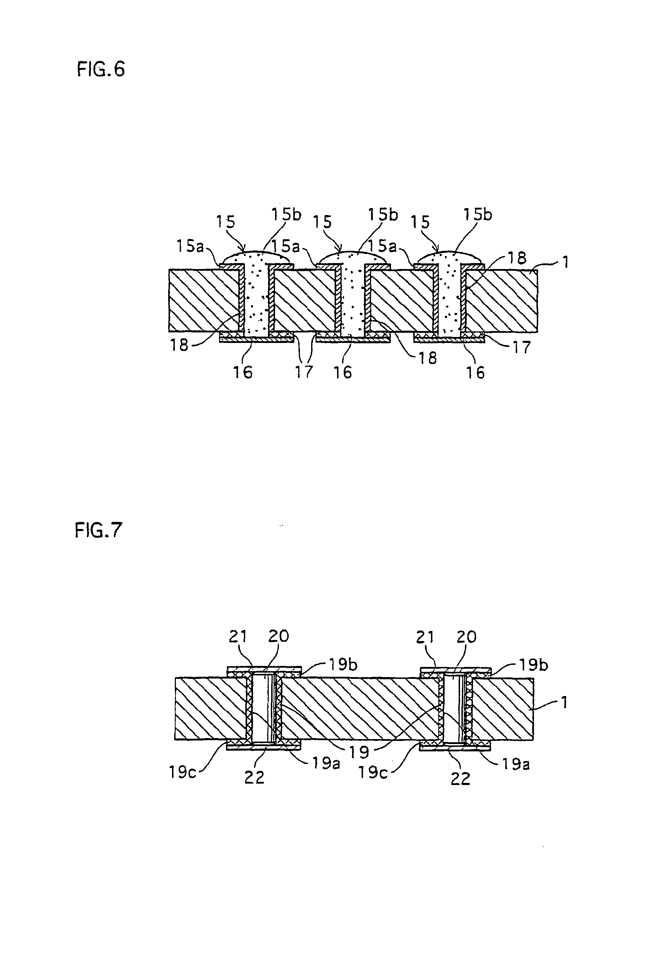

Fig. 6 is a sectional view of an important part of a surface mount circuit board according to an example.

The surfacemount circuit board includes the insulating substrate 1 having a plurality of through holes. Each through hole is at a location where a land is to be formed and extends from the front to rear surfaces of the insulating substrate 1. In addition, each through hole is provided with a copper plating 18 that covers the entire inner wall of the through hole. On the front surface of the insulating substrate. 1, copper platings 15a are provided one for each through hole. Each copper plating 15a covers part of the front surface around the peripheral edge of the through hole. On the rear surface of the insulating substrate 1, a plurality of pieces of copper foil 16 are provided to close off the respective through holes. Each copper foil piece 16 is adhesively attached the rear surface of the insulating substrate with an adhesive layer 17. Each through hole having the inner surface coated with the copper plating 18 is filled with solder cream 15b. The solder cream 15b not only fills the through hole but also flashes out of the through hole to form a solder mound 15b covering the copper plating 15a. Each copper plating 15a on the insulating substrate 1 and the solder mound 15b covering the copper plating 15a together serve as a land 15. Each copper foil piece 16 adhered to the rear surface of the insulating substrate 1 serves as a heat receiving member. The insulating substrate 1 has circuit wiring (not shown) formed on the front surface and one or more of the lands are connected to the circuit wiring.

In the surface mount circuit board having the above configuration, each land 15 composed of the solder mound 15b is thermally coupled to a corresponding one of the heat receiving members each composed of the copper foil piece 16 via the solder cream 15b, which serves as a high thermal conductive material filling the through holes.

Fig. 7 is a sectional view of an important part of a surface mount circuit board used in the method, according to a second embodiment of the present invention.

The surface mount circuit board in the method according to the second embodiment includes the insulating substrate 1 having a plurality of through holes. Each through hole is at a location where a land is to be formed and extends from the front to rear surfaces of the insulating substrate 1. In addition, each through hole is provided with a copper plating 19 that covers the entire inner wall of the through hole and also covers part of the front and rear surfaces of the insulating substrate 1 around peripheral edges of the through hole. Copper wires 20 are fitted into the respective through holes each having inner surface coated with the copper plating 19 (part 19a). On the front surface of the insulating substrate 1, copper platings 21 are provided one for each through hole. Each copper plating 21 covers an end surface of the copper wire 20 exposed at the front surface and also covers at lest part of the copper plating 19 (part 19b). On the rear surface of the insulating substrate 1, copper platings 22 are provided one for each through hole. Each copper plating 22 covers an end surface of the copper wire 20 exposed at the rear surface and also covers at least part of the copper plating 19 (part 19c). The copper platings 21 and 19b disposed on the front surface of the insulating substrate 1 together serve as a land. On the other hand, the copper platings 22 and 19c disposed on the rear surface of the insulating substrate 1 together serve as a heat receiving member. The insulating substrate 1 has circuit wiring (not shown) formed on the front surface and one or more of the lands are connected to the circuit wiring.

Note that each copper wire 20 shown in Fig. 7 appears to be longer than the thickness of the insulating substrate 1. In practice, however, each copper plating 19 is thin relatively to the insulating substrate 1. Thus, the thickness of the copper plating 19 is negligible to regard that the length of the copper wire 20 is substantially equal to the thickens of the insulating substrate 1.

In the circuit board having the above configuration, each land composed of the copper platings 21 and 19b is thermally coupled to a corresponding one of the heat receiving members each composed of the copper platings 22 and 19c via a corresponding one of the copper wires 20, each of which is a metal rod.

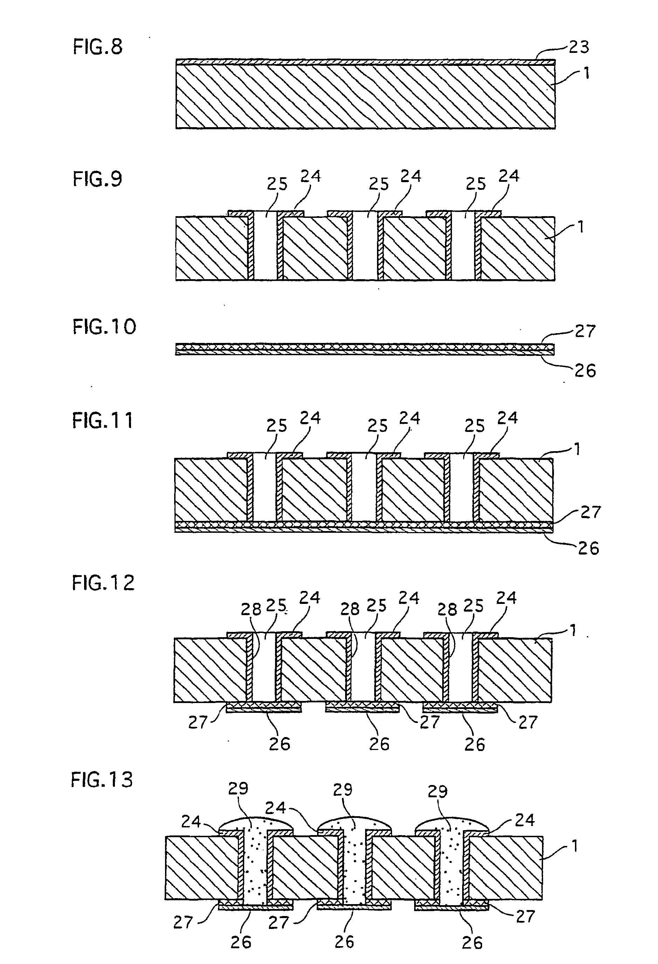

Figs. 8-13 are views illustrating steps of manufacturing a circuit board.

First of all, a single-sided copper clad laminate is prepared as a starting material (Fig. 8). The laminate is composed of the insulating substrate 1 and a copper layer 23 of a predetermined thickness coated on the front surface of the insulating substrate 1.

Next, the copper layer 23 on the front surface of the insulating substrate 1 is selectively etched to form circuit wiring (not shown). In addition, a plurality of copper platings 24 are formed on the front surface of the insulating substrate 1. Each copper plating 24 is formed at a location where a land is to be formed and serves as an undercoat for land. In addition, a plurality of holes 25 are formed through the insulating substrate 1 each at a location coinciding a center of a different one of the copper platings 24 (Fig. 9).

Next, a sheet of copper foil 26 having an adhesive layer 27 coated on one of the main surfaces is prepared (Fig. 10). The sheet of copper foil 26 is adhesively attached to the rear surface of the insulating substrate 1 (Fig. 11). As a result, the opening of each hole 25 appearing in the rear surface of the insulating substrate 1 is closed off by the sheet of copper foil 26. In this manner, the holes 25 are closed off simply by attaching the sheet of copper foil 26, which is relatively easy than by other means.

Next, the sheet of copper foil 26 that is adhesively attached to the rear surface of the insulating substrate 1 is selectively etched to leave portions resting on regions of the rear surface where lands are to be formed (Fig. 12). The pieces of copper foil 26 left unetched are physically separated and electrically insulated from one another. In the example shown in Fig. 12, three pieces of copper foil 26 are left unetched at locations corresponding to the respective copper platings 24.

At this stage of the manufacturing process, each hole 25 is already provided with a copper plating 28 covering the inner surface of the through hole. The step of forming the copper platings 28 may be performed either before or after the step of selectively etching the copper foil 26. Preferably, the step of forming the copper platings 28 and may be performed immediately after the step of forming the holes 25. The copper platings 28 may be formed through electroless copper plating using a copper sulfate bath, for example.

Each hole 25 is filled with solder cream 29. Here, the solder cream 29 is injected into each hole 25 until the sold cream 29 completely fills and flashes out of the hole 25 to form a solder mound covering the copper plating 24 (Fig. 13). At this stage of the manufacturing process, the hole 25 is already closed off at the rear surface of the insulating substrate 1 by the copper foil 26. Thus, the solder cream 29 is kept from leaking out from the opening at the rear surface of the insulating substrate 1.

With the above steps, the surface mount circuit board completes. In the surface mount circuit board, the solder cream 29 is used to form lands and also to fill the holes 25. Thus, the pieces of copper foil 26 attached to the rear surface of the insulating substrate 1 are thermally coupled to the respective lands via the solder cream 29. Consequently, the lands are heated by heating the pieces of copper foil 26.

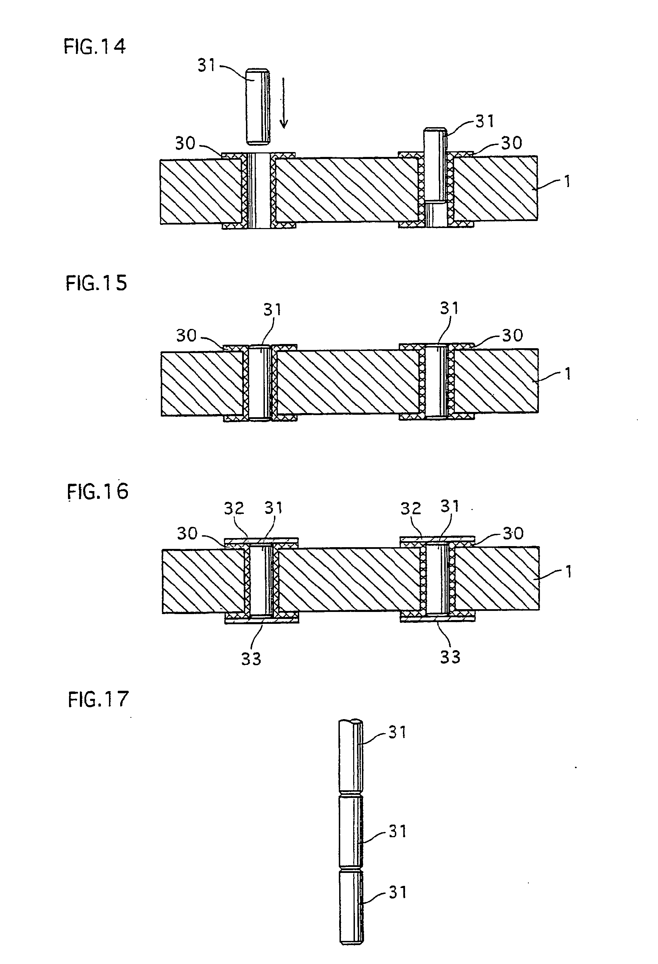

Figs. 14-17 are views illustrating steps of manufacturing the surface mount circuit board used in the method according to the second embodiment.

First of all, a plurality of through holes are formed through the insulating substrate 1. Each through hole is at a location corresponding to where a land is to be formed and extends from the front to rear surfaces of the insulating substrate 1. In addition, copper platings 30 are formed one for each through hole. Each copper plating 30 is formed to cover the inner surface of the through hole and also cover part of the front and rear surfaces of the insulating substrate 1 around the peripheral edges of the through hole. Then, the copper wires 31 are fitted into the respective through holes (Fig. 14). The copper platings 30 are formed by electroless copper plating using a copper sulfate bath, for example. In addition, the length of each copper wire 31 is selected to be substantially equal to the thickness of the insulating substrate 1 and the wire diameter is selected to be substantially equal to the inner diameter of each through hole. Each copper wire 31 is inserted into the through hole using, for example, a terminal-pin insertion machine, by applying a force pressing the wire in a direction indicated by the arrow in Fig. 14.

Note that the copper wires 31 shown in Fig. 14 are a plurality of separate pieces of wires. However, as shown in Fig. 17, it is applicable to use a single wirewithV-shaped grooves formed circumferentially therearound at intervals corresponding to thickness of the insulating substrate 1. That is to say, the single wire has a plurality of integral sections between the V-grooves. After inserting a section of the single wire into the through hole, the exposed part of the single wire may be cut off at the bottom of the V groove. By repeating this process, the plurality of copper wires 31 are obtained.

Fig. 15 shows the copper wires 31 fitted into the respective through holes. In the figure, each copper wire 31 appears to be longer than the width of the thickness of the insulating substrate 1. In practice, however, the thickness of the copper plating 30 is negligible to regard that the length of the copper wire 31 is substantially equal to the thickness of the insulating substrate 1.

Next, the copper platings 32 and 33 are formed one for each through hole. Each copper plating 32 is formed to cover an end surface of the copper wire 31 exposed on the front surface of the insulating substrate 1 and also to cover at least part of the copper plating 30 (Fig. 16). Similarly, each copper plating 33 is formed to cover an end surface of the copper wire 33 exposed on the rear surface of the insulating substrate 1 and also to cover at least part of the copper plating 30 (Fig. 16). Similarly to the copper platings 30, the copper platings 32 and 33 are formed through electroless copper plating using a copper sulfate bath, for example.

With the above steps, the surface mount circuit board used in the method according to the second embodiment completes. In the surface mount circuit board, each land composed of the copper plating 32 is thermally coupled to a corresponding one of the heat receiving members each composed of the copper plating 33 via a corresponding one of the copper wires 31.

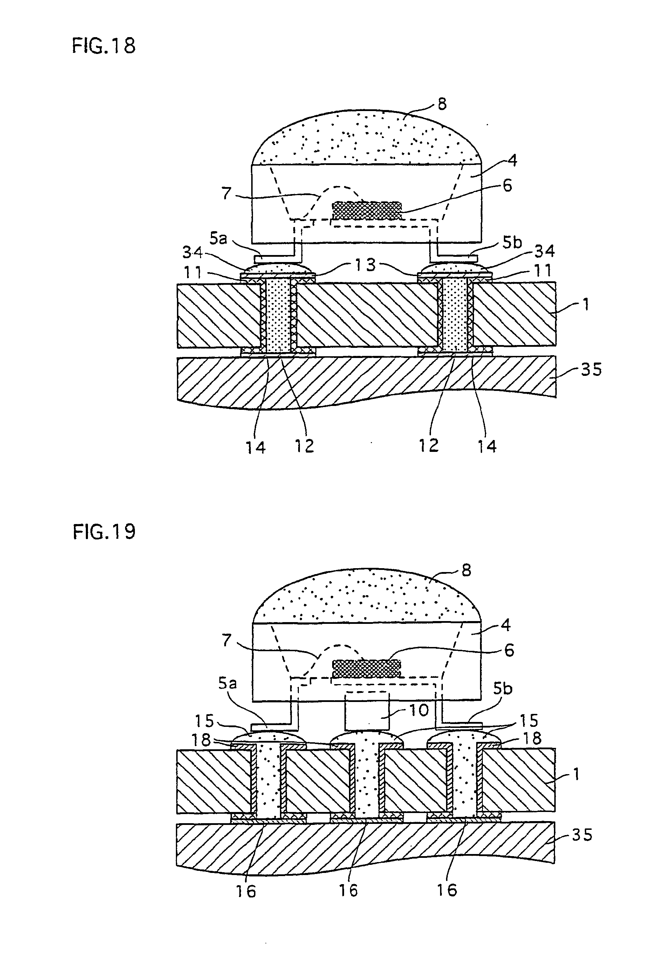

Fig. 18 is a view illustrating a step of mounting an LED onto the surface mount circuit board according to the first embodiment.

First of all, the solder mounds 34 are formed one on each copper plating 13 which serves as a land. Then, the LED is so placed that tip portions of the outer lead-wire-wires 5a and 5b seat against the respective solder mounds 34.

Next, a heating plate 35 that is heated to the melting point of the solder mounds 34 or higher is brought into contact with the copper platings 14 that are formed as heat receiving members on the rear surface of the insulating substrate 1. With this heating process, heat is conducted from the copper platings 14 to the copper platings 13 via the high thermal conductive epoxy resin 12. As a result, the solder mounds 34 melt and then solidify to bond the outer lead-wires 5a and 5b of the LED to the respective copper platings 13.

Fig. 19 is a view illustrating a step of mounting an LED onto a surface mount circuit board.

First of all, the LED is so placed that tip portions of the outer lead-wires 5a and 5b as well as the heat-dissipating block 10 seat on the respective lands 15.

Next, the heating plate 35 that is heated to the melting point of the solder cream or higher is brought into contact with the copper foil pieces 16 that are formed as heat receiving members on the rear surface of the insulating substrate 1. With this heating process, heat is conducted from the copper foil pieces 16 to the solder cream. As a result, the solder cream melts and then solidifies to bond the outer lead-wires 5a and 5b as well as the heat-dissipating block 10 of the LED onto the respective lands 15.

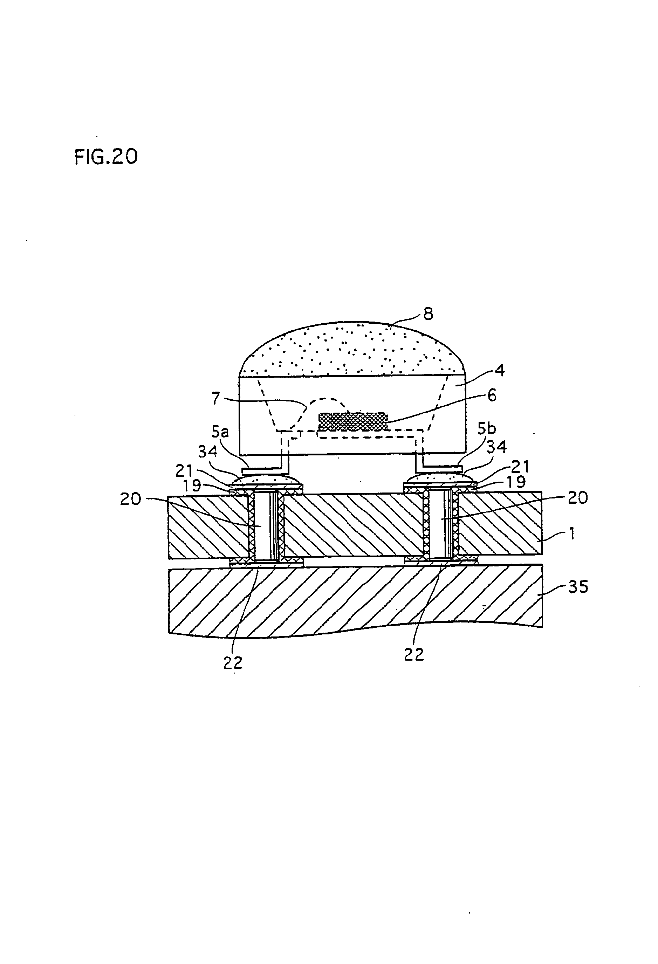

Fig. 20 is a view illustrating a step of mounting an LED noto the circuit board according to the second embodiment.

First of all, on each copper plating 21, the solder mound 34 serving as a land is formed. Next, the LED is so placed that tip portions of the outer lead-wires 5a and 5b seat on the respective solder mounds 34.

Next, the heating plate 35 that is heated to the melting point of the solder mounds 34 or higher is brought into contact with the copper platings 22 that are formed as heat receiving members on the rear surface of the insulating substrate 1. With this heating process, heat is conducted from the copper platings 22 to the copper platings 21 via the copper wires 20. As a result, the solder mounds 34 melt and then solidify to bond the outer lead-wires 5a and 5b of the LED to the respective copper platings 21.

According to the above methods of mounting surface mount electronic devices, the heating plate is placed to be in contact with the rear surface of the insulating substrate. Therefore, the insulating substrate acts as a shield against heat to significantly reduce thermal effect imposed on the surface mount electronic devices. In addition, with a relatively simple structure employing, for example, a heating plate, local heating of any land formed on the insulating substrate is feasible. In addition, since the insulating substrate is heated from the rear surface, no restrictions are imposed at all on locations of surface mount electronic devices.

Note that the above description mentions an LED as an example of surface mount electronic devices. Yet, the present invention is not limited to such. Most resin-molded surface mount electronic devices are heat sensitive and thus susceptible to adverse effect such as thermal deformation of molded resin upon directly receiving thermal stresses resulting from heating in the soldering process. By employing the surface mount circuit board and the mounting method both according to the present invention to mount such a heat-sensitive surface mount electronic device, thermal effect at the time of heating is significantly reduced. As a consequence, deterioration of circuit performance is avoided.

In addition, applications of the present invention are not limited to circuit mounting of a heat-sensitive surface mount electronic device. The present invention is applicable also to wide variety of fields including mounting of an electronic device less sensitive to heat. With the present invention, circuit mounting is carried out with a simple structure.

Note in addition that the above description mentions that a heating plate is used for heating. However, the present invention is not limited to such and any other heat source may be employed. For example, the rear surface of the surface mount circuit board may be heated by radiant heat transferred from far infrared radiation as a heat source.

Note in addition that the first embodiment mentions as the high thermal conductive material a high thermal conductive epoxy resin obtained by kneading copper powder. However, the present invention is not limited to such and any other material may be used as long as the material is highly thermally conductive and suitable for filling through holes. Examples of such materials include high thermal conductive plastic obtained by kneading, as high thermal conductive filler, powder of silicon oxide or aluminum oxide.

Note in addition that the example mentions that the copper foil is attached to the rear surface of the insulating substrate. However, the present invention is not limited to such and any metal foils other than copper foil may be uses.

Note in addition that the second embodiment mentions the copper wire as a metal rod. However, the present invention is not limited to such and any metal wire other than cooper wire may be employed. One example of such a wire is an aluminum wire.

Although the present invention has been fully described by way of examples with reference to the accompanying drawings, it is to be noted that various changes and modifications will be apparent to those skilled in the art. Therefore, unless such changes and modifications depart from the scope of the present invention which is defined by the appended claims, they should be construed as being included therein.

## Claims

1. A method for mounting surface mount electronic devices, comprising the steps of
forming a plurality of through holes (25) each extending from front to rear surfaces of an insulating substrate (1) and each at a location corresponding to where a land is to be formed;
fitting a plurality of metal rods (20) each into a different one of the through holes, each metal rod being substantially equal in length to a thickness of the insulating substrate, or filling a high thermal conductive material (12) into the respective through holes to form a plurality of high thermal conductive members;
forming a plurality of lands (13, 21) on the front surface of the insulating substrate, so that each land is in contact with a first end surface of a different one of the metal rods or the high thermal conductive members and with part of the front surface around a peripheral edge of the corresponding through hole;
forming a plurality of heat receiving members (14, 22) on the rear surface of the insulating substrate, so that each heat receiving member is in contact with a second end surface of a different one of the metal rods or the high thermal conductive members and with part of the rear surface around a peripheral edge of the corresponding through hote:
applying solder (34) to each land;
placing a plurality of surface mount electronic devices each relative to a different one of the lands, so that at least an outer lead-wire of the surface mount electronic device engages with the solder applied to the land; and
heating the heat receiving members (14, 22) by placing the heat receiving members into contact with a flat surface of a heater (35) so that the solder is melted to bond the outer lead-wire of each surface mount electronic device to the corresponding land.

2. The method according to claim 1, further comprising the step of:
forming, for each through hole, a first plating film covering part of the front and rear surfaces around the peripheral edge of the through hole, the first plating film forming step being performed between the through hole forming step and the metal rod fitting step or high thermal conductive material filling step,
to form each land in the land forming step, a second plating film is formed to cover the first end surface of the metal rod or the high thermal conductive member and at least part of the first plating film, and
to form each heat receiving member in the heat receiving member forming step, a third plating film is formed to cover the second end surface of the metal rod or high thermal conductive member and at least part of the rear surface around the peripheral edge of the through hole.

3. The method according to claim 2, wherein
each metal rod is made of copper.

## Patentansprüche

1. Verfahren zum Aufbau von Oberflächenmontage-Elektronikvorrichtungen, umfassend die folgenden Schritte:
Bilden einer Vielzahl von Durchgangslöchern (25), von denen sich jedes von einer vorderen zu einer hinteren Oberfläche eines isolierenden Substrats (1) erstreckt und jedes sich an einer Position befindet, an der ein Lötauge zu bilden ist;
Setzen einer Vielzahl von Metallstäben (20), jeden in einen verschiedenen einen der Durchgangslöcher, wobei jeder Metallstab im Wesentlichen gleich in der Länge zu einer Dickte des isolierenden Substrats ist, oder Füllen eines thermisch hoch leitenden Materials (12) in die jeweiligen Durchgangslöcher, um eine Vielzahl von thermisch hoch leitenden Gliedern zu bilden;
Bilden einer Vielzahl von Lötaugen (13, 21) auf der vorderen Oberfläche des isolierenden Substrats, so dass jedes Lötauge mit einer ersten Endoberfläche eines verschiedenen einen der Metallstäbe oder der thermisch hoch leitenden Glieder oder mit einem Teil der vorderen Oberfläche um einer Umfangskante des korrespondierenden Durchgangslochs in Kontakt ist;
Bilden einer Vielzahl von Wärme empfangenden Gliedern (14, 22) auf der hinteren Oberfläche des isolierenden Substrats, so dass jedes Wärme empfangende Glied mit einer zweiten Endoberfläche eines verschiedenen einen der Metallstäbe oder der thermisch hoch leitenden Glieder und mit einem Teil der hinteren Oberfläche um einer Umfangskante des korrespondierenden Durchgangslochs in Kontakt ist;
Auftragen von Lötmittel (34) auf jedes Lötauge;
Platzieren einer Vielzahl von Oberflächenmontage-Elektronikvorrichtungen, jede relativ zu einem verschiedenen einen der Lötaugen, so dass mindestens ein äußerer Anschlussdraht der Oberflächenmontage-Elektronikvorrichtung mit dem auf dem Lötauge aufgetragenen Lötmittel in Eingriff kommt; und
Erwärmen der Wärme empfangenden Glieder (14, 22) durch Platzieren der Wärme empfangenden Glieder in Kontakt mit einer ebenen Oberfläche einer Heizung (35), so dass das Lötmittel geschmolzen wird, um den äußeren Anschlussdraht jeder Oberflächenmontage-Elektronikvorrichtung an das korrespondierende Lötauge zu binden.

2. Verfahren nach Anspruch 1, weiter den folgenden Schritt umfassend:
Bilden, für jedes Durchgangsloch, eines ersten Plattierungsfilms, der einen Teil der vorderen und hinteren Oberfläche um die Umfangskante des Durchgangslochs abdeckt, wobei der Schritt zum Bilden des ersten Plattierungsfilms zwischen dem Schritt zum Bilden des Durchgangslochs und dem Schritt zum Setzen der Metallstäbe oder dem Schritt zum Füllen mit thermisch hoch leitendem Material durchgeführt wird,
wobei zum Bilden jedes Lötauges in dem Schritt zum Bilden der Lötaugen ein zweiter Plattierungsfilm gebildet wird, um die erste Endoberfläche des Metallstabs oder des thermisch hoch leitenden Glieds und mindestens einen Teil des ersten Plattierungsfilms abzudecken, und
wobei zum Bilden jedes Wärme empfangenden Glieds in dem Schritt zum Bilden der Wärme empfangenden Glieder ein dritter Plattierungsfilm gebildet wird, um die zweite Endoberfläche des Metallstabs oder des thermisch hoch leitenden Glieds und mindestens einen Teil der hinteren Oberfläche um die Umfangskante des Durchgangslochs abzudecken.

3. Verfahren nach Anspruch 2, wobei
jeder Metallstab aus Kupfer hergestellt ist.

## Revendications

1. Procédé de montage de dispositifs électroniques à montage en surface, comprenant les étapes consistant à :
former une pluralité de trous débouchants (25) s'étendant chacun depuis des surfaces avant jusqu'à des surfaces arrière d'un substrat isolant (1) et chacun à un emplacement correspondant à l'endroit où une plage doit être formée ;
placer une pluralité de tiges métalliques (20) chacune dans un trou différent des trous débouchants, chaque tige métallique étant sensiblement égale en longueur à une profondeur du substrat isolant, ou remplir un matériau à haute conductivité thermique (12) dans les trous débouchants respectifs afin de former une pluralité d'éléments à haute conductivité thermique ;
former une pluralité de plages (13, 21) sur la surface avant du substrat isolant, de telle sorte que chaque plage soit en contact avec une première surface d'extrémité d'une tige différente des tiges métalliques ou d'un élément différent des éléments à haute conductivité thermique et avec une partie de la surface avant autour d'un bord périphérique du trou débouchant correspondant ;
former une pluralité d'éléments récepteurs de chaleur (14, 22) sur la surface arrière du substrat isolant, de telle sorte que chaque élément récepteur de chaleur soit en contact avec une seconde surface d'extrémité d'une tige différente des tiges métalliques ou d'un élément différent des éléments à haute conductivité thermique et avec une partie de la surface arrière autour d'un bord périphérique du trou débouchant correspondant ;
appliquer de la brasure (34) sur chaque plage ;
placer une pluralité de dispositifs électroniques à montage en surface chacun relativement à une plage différente des plages, de telle sorte qu'au moins un fil de sortie externe du dispositif électronique à montage en surface s'engage avec la brasure appliquée sur la plage ; et
chauffer les éléments récepteurs de chaleur (14, 22) en plaçant les éléments récepteurs de chaleur en contact avec une surface plate d'un radiateur (35) de telle sorte que la brasure soit fondue pour fixer le fil de sortie externe de chaque dispositif électronique à montage en surface sur la plage correspondante.

2. Procédé selon la revendication 1, comprenant en outre l'étape consistant à :
former, pour chaque trou débouchant, un premier film de placage couvrant une partie des surfaces avant et arrière autour du bord périphérique du trou débouchant, l'étape de formation d'un premier film de placage étant exécutée entre l'étape de formation de trous débouchants et l'étape de placement de tiges métalliques ou l'étape de remplissage d'un matériau à haute conductivité thermique,
pour former chaque plage dans l'étape de formation de plages, un second film de placage est formé pour couvrir la première surface d'extrémité de la tige métallique ou de l'élément à haute conductivité thermique et au moins une partie du premier film de placage, et
pour former chaque élément récepteur de chaleur dans l'étape de formation d'élément récepteur de chaleur, un troisième film de placage est formé pour couvrir la seconde surface d'extrémité de la tige métallique ou de l'élément à haute conductivité thermique et au moins une partie de la surface arrière autour du bord périphérique du trou débouchant.

3. Procédé selon la revendication 2, dans lequel chaque tige métallique est réalisée en cuivre.
